(19) Europäisches Patentamt
European Patent Office
Office européen des brevets

(11) **EP 1 936 812 A1**

(12) **DEMANDE DE BREVET EUROPEEN**

(43) Date de publication:
**25.06.2008 Bulletin 2008/26**

(51) Int Cl.:
**H03M 13/25** *(2006.01)*

(21) Numéro de dépôt: **07123401.7**

(22) Date de dépôt: **17.12.2007**

(84) Etats contractants désignés:
**AT BE BG CH CY CZ DE DK EE ES FI FR GB GR HU IE IS IT LI LT LU LV MC MT NL PL PT RO SE SI SK TR**
Etats d'extension désignés:
**AL BA HR MK RS**

(30) Priorité: **18.12.2006 FR 0655598**

(71) Demandeur: **COMMISSARIAT A L'ENERGIE ATOMIQUE**
**75015 Paris (FR)**

(72) Inventeur: **Calvanese Strinati, Emilio**
**38000 Grenoble (FR)**

(74) Mandataire: **Ilgart, Jean-Christophe et al**
**BREVALEX**
**3, rue du Docteur Lancereaux**
**75008 Paris (FR)**

(54) **Récepteur à décodage conditionnel**

(57) La présente invention concerne un récepteur de système de télécommunication sans fil, comprenant un démodulateur (220, 230) adapté à démoduler un signal reçu d'une source via un canal de transmission pour fournir un mot de code correcteur d'erreurs sous forme de valeurs souples ou dures, un décodeur (240) adapté à effectuer le décodage dudit mot de code, caractérisé en ce qu'il comprend en outre des moyens de décision (250) adaptés à recevoir une estimation des coefficients d'évanouissement dudit canal pendant la transmission dudit mot de code ainsi qu'une estimation de la variance de bruit ou de rapport signal à bruit, à en déduire une estimation de l'information mutuelle instantanée relative au dit canal, et à décider d'inhiber ou non le décodage du mot de code par le décodeur, selon que le taux binaire de transmission de la source est respectivement supérieur ou inférieur à un seuil caractéristique de ladite information mutuelle instantanée.

FIG. 2

**Description**

**DOMAINE TECHNIQUE**

La présente invention concerne le domaine du décodage et plus particulièrement du décodage itératif. Elle trouve notamment application dans les récepteurs de systèmes de télécommunication sans fil.

**ÉTAT DE LA TECHNIQUE ANTÉRIEURE**

Les algorithmes de décodage itératif sont bien connus de l'état de la technique, que ce soit dans le cadre du turbo-décodage ou, de manière plus générale dans le cadre du décodage par passage de messages dans un graphe bipartite. On trouvera par exemple une description détaillée d'algorithmes de turbo-décodage dans l'article de J. Hagenauer et al. intitulé « Iterative decoding of binary block and convolutional codes » publié dans IEEE Trans. on Information Theory, vol. 42, N° 2, Mars 1996, pages 429-445.

Schématiquement, les algorithmes de décodage itératif effectuent plusieurs étapes de décodage élémentaire d'un bloc de données, chaque étape utilisant une information d'entrée dite *a priori* et générant, à partir de la connaissance de la loi de codage, une information de sortie dite *a posteriori,* de plus grande fiabilité que l'information d'entrée. Le supplément d'information par rapport à l'information d'entrée est appelé information extrinsèque. Cette information extrinsèque est prise en compte pour générer l'information *a priori* à l'étape suivante. Chaque étape de décodage élémentaire bénéficie ainsi d'une information *a priori* de fiabilité accrue par rapport à l'étape précédente.

En principe, le procédé de décodage itératif converge au bout d'un certain nombre d'itérations. Le critère d'interruption des itérations a fait l'objet de nombreuses recherches. Il est en effet important, tout particulièrement en téléphonie mobile, où les ressources du récepteur sont limitées, de réduire autant que possible le nombre d'itérations effectuées, et par conséquent aussi bien l'énergie consommée que le temps de latence.

Une solution triviale consiste à fixer un nombre prédéterminé d'itérations. Toutefois ce nombre peut s'avérer être insuffisant pour des conditions de transmission de faible rapport signal à bruit, auquel cas le taux d'erreurs en sortie du décodeur devient anormalement élevé, ou bien au contraire trop important, auquel cas un certain nombre d'itérations sont effectuées en pure perte.

La plupart des critères d'interruption proposés dans la littérature sont basés sur l'observation des informations *a priori* au fur et à mesure des itérations successives. Certains critères mesurent le degré de fiabilité du résultat du décodage en sortie de chaque itération, d'autres mesurent leur évolution. On comprendra que la croissance en valeur absolue d'une valeur souple d'information *a priori,* lorsqu'elle est exprimée sous forme de logarithme de rapport de vraisemblance, est significative du degré de convergence du procédé de décodage.

Parmi les critères d'interruption connus on peut citer celui de l'écart entropique entre les informations *a posteriori* issues de deux itérations successives, tel qu'exposé dans l'article précité, ainsi que ses dérivés, comme ceux décrits par exemple dans l'article de R.Y. Shao et al. intitulé « Two simple stopping criteria for turbo decoding » publié dans IEEE Transactions on Communications, vol. 47, pages 117-120, Août 1999, ou bien encore ceux fondés sur les propriétés statistiques des valeurs extrinsèques, tels que décrits dans les demandes de brevet EP-A-1334562 et EP-A-1128589. L'article de A. Matache et al. intitulé « Stopping rules for turbo decoders » paru en 2000 dans TMO Progress report 42-142, Jet Propulsion Laboratory, passe en revue un certain nombre de critères d'interruption opérant sur les valeurs dures ou les valeurs souples d'information *a posteriori.*

Les critères d'interruption précités ont été conçus pour un canal à bruit blanc additif et gaussien, encore dit BBAG. En pratique, toutefois, les canaux de transmission des systèmes de télécommunication sans fil, que ce soit des systèmes de type multiporteuse comme IEEE 802.11a, IEEE 802.11g ou des systèmes à sauts de fréquence tels que les systèmes GSM ou EDGE (*Enhanced Data GSM Environment*) ou encore des systèmes à étalement de spectre tels que le système UMTS, ne peuvent être modélisés par un canal BBAG mais par un canal à évanouissements par blocs.

En outre, les critères d'interruption ne s'appliquent bien entendu qu'au cours du décodage itératif. On ne dispose pas à l'heure actuelle d'un critère permettant de déterminer à l'avance si le décodage itératif pourra converger ou non.

Même en l'absence de tout décodage itératif, un récepteur d'un système de télécommunication procède classiquement au décodage du code correcteur d'erreurs appliqué en transmission, que ce soit un code par blocs, un code convolutif ou un code concaténé. Lorsque les conditions de transmission sont mauvaises, il arrive que le procédé de décodage ne puisse corriger toutes les erreurs affectant le bloc reçu. Dans ce cas, le récepteur envoie généralement une requête automatique de retransmission ou ARQ (Automatic Repeat reQuest) à l'émetteur. Toutefois, le décodage du mot erroné aura alors grevé inutilement les ressources du récepteur, tant en termes d'énergie consommée qu'en temps de latence.

Le but de la présente invention est de permettre au récepteur de décider au préalable s'il y a lieu de procéder au décodage du code reçu, en particulier à un décodage itératif, afin de ne pas grever inutilement ses ressources.

## EXPOSÉ DE L'INVENTION

La présente invention est définie par un récepteur de système de télécommunication sans fil, comprenant un démodulateur adapté à démoduler un signal reçu d'une source via un canal de transmission pour fournir un mot de code correcteur d'erreurs sous forme de valeurs souples ou dures, un décodeur adapté à effectuer le décodage dudit mot de code, le récepteur comprenant en outre des moyens de décision adaptés à recevoir une estimation des coefficients d'évanouissement dudit canal pendant la transmission dudit mot de code ainsi qu'une estimation de la variance de bruit ou de rapport signal à bruit, à en déduire une estimation de l'information mutuelle instantanée relative au dit canal, et à décider d'inhiber ou non le décodage du mot de code par le décodeur, selon que le taux binaire de transmission de la source est respectivement supérieur ou inférieur à un seuil caractéristique de ladite information mutuelle instantanée.

L'information mutuelle instantanée est avantageusement estimée comme l'information mutuelle moyenne entre l'entrée et la sortie dudit canal pendant la durée de transmission du mot de code.

Selon une première variante, le canal étant du type à une antenne d'émission et une antenne de réception, l'information mutuelle instantanée est calculée selon :

$$I_{inst} = \frac{1}{n_c} \sum_{i=1}^{n_c} I_i$$

$$I_i = \log Q - \frac{1}{Q} \sum_{k=1}^{Q} E_z \left\{ \log\left( \sum_{q=1}^{Q} \exp\left[ -\frac{\left|h_i a_k + z - h_i a_q\right|^2 - |z|^2}{2\sigma^2} \right] \right) \right\}$$

où $\boldsymbol{n_c}$ est le nombre de coefficients d'évanouissement $h_i; i=1,..,n_c$ du canal affectant le mot de code, $Q$ et $a_k; k = 1,..Q$ sont respectivement le cardinal et les éléments de l'alphabet de modulation binaire à symbole utilisée pour moduler le mot de code avant sa transmission sur ledit canal, $\sigma^2$ est la variance du bruit affectant le canal, $z$ un échantillon de bruit suivant une loi $N(0,\sigma^2)$ et $E_z$ l'espérance sur $z$.

Selon une seconde variante, le canal étant du type à une antenne d'émission et une antenne de réception, l'information mutuelle instantanée du canal est estimée à partir de :

$$C_{inst} = \frac{\gamma}{n_c} \sum_{i=1}^{n_c} |h_i|^2$$

où $n_c$ est le nombre de coefficients d'évanouissement $h_i; i = 1,..,n_c$ du canal affectant le mot de code et $\gamma$ est le rapport signal à bruit en réception.

De préférence, ladite valeur de seuil est égale à l'information mutuelle instantanée du canal diminuée d'une valeur d'offset strictement positive.

La valeur d'offset peut être fonction d'au moins un paramètre appartenant au groupe constitué du niveau de charge de la batterie du récepteur, du type de codage dudit mot de code, du temps de latence maximal, du type de modulation et/ou du cardinal de l'alphabet de modulation utilisé pour moduler ledit mot de code avant sa transmission sur le canal.

En outre, si le temps de vie d'un paquet contenant ledit mot de code est expiré, le décodage peut être aussi inhibé.

Avantageusement, le décodeur effectue un décodage itératif et peut être adapté à interrompre les itérations de décodage sur la base de l'écart entropique des informations *a priori* fournies par deux itérations successives ou, alternativement, sur la base d'une mesure de fiabilité des informations *a priori.*

## BRÈVE DESCRIPTION DES DESSINS

D'autres caractéristiques et avantages de l'invention apparaîtront à la lecture d'un mode de réalisation préférentiel de l'invention fait en référence aux figures jointes parmi lesquelles:

La Fig. 1 représente un mot de code destiné à être transmis sur un canal de transmission à évanouissements par blocs ;
La Fig. 2 représente schématiquement un récepteur d'un système de télécommunication sans fil, selon un mode de réalisation de l'invention.

## EXPOSÉ DÉTAILLÉ DE MODES DE RÉALISATION PARTICULIERS

Nous considérerons tout d'abord le cas d'un système de télécommunication sans fil, par exemple un système de télécommunication radiomobile, ayant une configuration SISO (*Single Input Single Output*), c'est-à-dire à une seule antenne de transmission et une seule antenne de réception, le canal de transmission peut alors être modélisé de la manière suivante :

$$y_i = h_i x_i + z_i , \quad i = 1,...,N \tag{1}$$

où $x_i$ et $y_i$ représentent respectivement les signaux transmis et reçu à l'instant $t_i = iT$ où $T$ est la période symbole et $N$ est le nombre de symboles dans le bloc, $z_i$ est un échantillon de bruit BBAG de moyenne nulle et de variance $\sigma^2$ et les coefficients d'évanouissement $h_i$ sont des échantillons de variables aléatoires indépendantes et identiquement distribuées (i.i.d.), typiquement selon une loi de Rayleigh.
On sait que la capacité d'un canal au sens de Shannon est définie comme le maximum de l'information mutuelle moyenne $I(X,Y)$, $X$ et $Y$ étant des variables aléatoires respectivement associées à l'entrée et à la sortie du canal. Par information mutuelle moyenne on doit comprendre une information mutuelle moyennée sur les valeurs possibles $x$ de la variable aléatoire d'entrée $X$ et les valeurs possibles $y$ de la variable aléatoire de sortie $Y$.
Pour un canal sans mémoire, c'est-à-dire pour un canal dont la sortie à un instant donné dépend seulement de l'entrée à cet instant et non des entrées et sorties précédentes, la capacité est définie comme le maximum de l'information mutuelle moyenne sur toutes les distributions possibles $p_x$ de la variable d'entrée $X$, soit :

$$C = \max_{p_X, P \leq P_T} I(X,Y) \tag{2}$$

où $P = E\left\{|x^2|\right\}$ est la puissance moyenne du signal d'entrée et $P_T$ est la puissance maximale de l'émetteur.

On rappelle que l'information mutuelle moyenne d'un couple de variables aléatoires $X,Y$ est définie dans le cas continu par :

$$I(X,Y) = \iint p_{X,Y}(x,y) \log \frac{p_{X,Y}(x,y)}{p_X(x)p_Y(y)} dxdy \tag{3}$$

où $p_{X,Y}(x,y)$ est la densité de probabilité conjointe de $X$ et $Y$ et $p_X(x)$, $p_Y(y)$ les densités de probabilité de $X$ et $Y$ respectivement.
Nous supposerons tout d'abord que le canal est ergodique, c'est-à-dire que $h(iT)$ este un processus aléatoire à temps discret ergodique. La capacité ergodique, ou capacité au sens de Shannon, du canal SISO modélisé par (1) s'exprime comme:

$$C = E_H\left\{\max_{p(x),P \leq P_T} \left(I(X,Y)\right)\right\} \tag{4}$$

où $E_H\{.\}$ indique l'espérance sur la loi de probabilité des coefficients $h_i$.

On montre que la capacité ergodique du canal à évanouissements s'écrit alors :

$$C = E_H \left\{ \log(1 + \gamma |h|^2) \right\} \qquad (5)$$

où $\gamma$ est le rapport signal à bruit (SNR) en réception. Le terme générique $h$ a été utilisé en raison de l'identité des lois de probabilité des coefficients $h_i$.

De même, on montre qu'un canal MIMO (*Multiple Input Multiple Output*) c'est-à-dire à pluralité d'antennes d'émission et pluralité d'antennes de réception peut être modélisé par :

$$\mathbf{y_i} = \mathbf{H_i}\mathbf{x_i} + \mathbf{z_i} \qquad i = 1,..,N \qquad (6)$$

où ici les $\mathbf{x_i}$ et $\mathbf{y_i}$ sont respectivement les vecteurs des signaux émis par les $M$ antennes d'émission, et reçus par les $P$ antennes de réception, $\mathbf{H_i}$ est la matrice des coefficients de propagation entre les antennes d'émission et de réception, $\mathbf{z_i}$ est un vecteur d'échantillons de bruit BBAG et $N$ est le nombre d'utilisations du canal. On suppose que les coefficients des matrices $\mathbf{H_i}$ sont des échantillons de variables aléatoires *i.i.d*.

La capacité du canal MIMO est définie de manière similaire à (2) :

$$C = \max_{p_{\mathbf{X}}, tr(\mathbf{R_{xx}}) \leq P_T} I(\mathbf{X}, \mathbf{Y}) \qquad (7)$$

où $\mathbf{X}$ et $\mathbf{Y}$ sont respectivement des vecteurs aléatoires en entrée et sortie du canal et $\mathbf{R_{xx}} = E(\mathbf{x}\tilde{\mathbf{x}})$ est la matrice de covariance du vecteur aléatoire $\mathbf{X}$. On suppose dans la suite que les composantes de $\mathbf{X}$ sont indépendantes et que donc

$$\mathbf{R_{xx}} = \frac{P_T}{M}\mathbf{I_M}$$

où $P_T$ est la puissance totale de l'émetteur.

On montre que la capacité ergodique du canal MIMO à évanouissements s'écrit, de manière similaire à (5) :

$$C = E_H \left\{ \log\left[ \det\left( \mathbf{I_P} + \frac{\gamma}{M}\mathbf{H}\tilde{\mathbf{H}} \right) \right] \right\} \qquad (8)$$

où $\mathbf{I_P}$ est la matrice identité de taille $P \times P$,

$$\gamma = \frac{P_T}{\sigma^2}$$

désigne le rapport signal à bruit et $\tilde{\mathbf{H}}$ la transposée conjuguée de la matrice $\mathbf{H}$.

L'invention part de la constatation que les canaux rencontrés dans les systèmes de télécommunication radiomobile ne sont généralement pas ergodiques. La capacité au sens de Shannon est d'ailleurs nulle et ne permet pas de caractériser ce type de canaux. Pour cette raison, on introduit la notion de probabilité de coupure (*Outage Probability*), définie comme la probabilité que l'information mutuelle instantanée soit inférieure au taux binaire de transmission par utilisation du canal, notée $R$, exprimé en bits (ou plus précisément en shannons) par utilisation du canal.

On entend par information mutuelle instantanée, l'information mutuelle moyenne pour une instance du canal, la moyenne étant prise comme en (3) sur les échantillons de variables aléatoires $X, Y$ respectivement en entrée et sortie du canal.

La probabilité de coupure dépend du rapport signal à bruit $\gamma$ et du taux binaire de transmission $R$, soit:

$$P_{out}(\gamma, R) = \Pr\big(I(X,Y) < R\big) \tag{9}$$

Par exemple, pour un code correcteur $(n,k,d_{min})$ et un alphabet de modulation de cardinal $Q$, le taux binaire de transmission vaut

$$R = \frac{k}{n}\log Q \ .$$

On rappelle qu'un code noté conventionnellement $(n,k,d_{min})$ est un code de longueur $n$, de dimension $k$ et de distance minimale $d_{min}$.

La probabilité de coupure peut être vue comme la probabilité que l'information mutuelle instantanée du canal soit inférieure au taux binaire de transmission. Si celle-ci est inférieure à ce taux, il ne sera pas possible de décoder les mots de codes sans erreur et donc inutile de procéder à un décodage. En revanche, en faisant le parallèle avec le théorème fondamental de Shannon, si l'information mutuelle instantanée de la source est supérieure à ce taux, il sera toujours possible d'utiliser un code correcteur permettant de transmettre les données avec une probabilité d'erreur arbitrairement faible.

Alors que la capacité ergodique d'un canal représente la plus grande quantité d'information dont il peut en moyenne assurer le transfert (la moyenne étant prise sur les instances du canal), l'information mutuelle instantanée représente la quantité d'information dont il peut assurer le transfert pour une instance de canal déterminée. L'information mutuelle instantanée est fonction des coefficients d'évanouissement de l'instance du canal et du rapport signal à bruit.

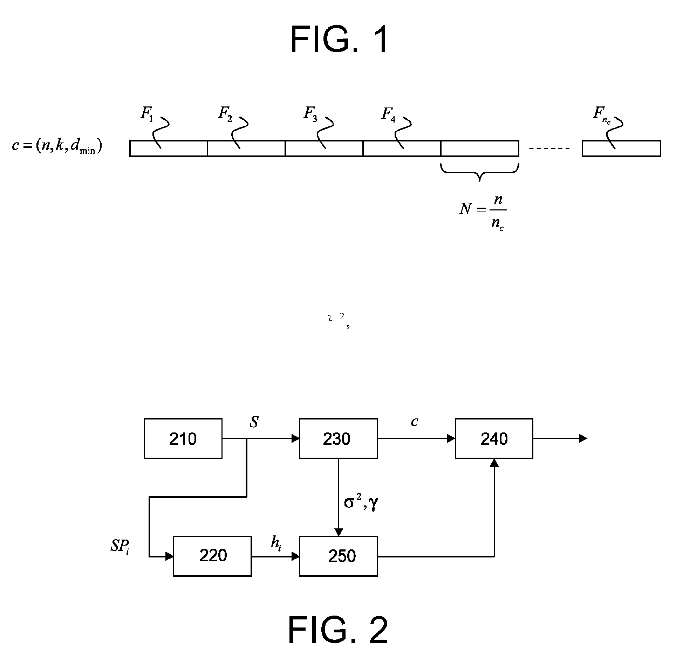

Nous considérons maintenant le cas d'un canal de transmission à évanouissements par blocs. On a représenté en Fig. 1 un mot de code $(n,k,d_{min})$ avant modulation binaire à symbole (par ex. BPSK) et transmission sur le canal. Le mot de code est schématiquement divisé en $\boldsymbol{n_c}$ blocs de taille

$$N = \frac{n}{n_c} \, ,$$

désignés par $F_1,..,F_{nc}$, chaque bloc $F_i$ étant affecté par un coefficient d'évanouissement $h_i$.

Il est important de comprendre que la partition par blocs du mot de code ne préjuge pas de la manière dont les bits sont transmis. Ainsi un bloc pourra correspondre à un ensemble de porteuses contiguës d'un symbole OFDM ou bien à un intervalle temporel : dans le premier cas la réponse du canal est constante par bandes spectrales, dans le second par intervalles temporels. Un bloc pourra encore être défini conjointement par une bande spectrale et un intervalle temporel.

Un canal à évanouissements par blocs est quelquefois appelé non-ergodique ou quasi-statique, car un mot de code ne voit qu'un nombre fini ($n_c$) de coefficients d'évanouissement. Ces coefficients peuvent être compris comme le résultat de $n_c$ tirages d'une variable aléatoire, par exemple ayant une loi de distribution de Rayleigh. On note $\mathbf{h}$ le vecteur des coefficients $h_i$, $i=1,..,n_c$,

Le taux d'erreur pour un paquet (PER) de $\ell$ bits décodés peut s'écrire :

$$PER = \int_{\mathbf{h}} p(\mathbf{h})\Big(1-\big(1-P_e(\mathbf{h})\big)^{\ell}\Big)d\mathbf{h} \tag{10}$$

où la somme est calculée sur l'espace des coefficients d'évanouissement, $P_e(\mathbf{h})$ est la probabilité d'erreur par bit connaissant $\mathbf{h}$, $p(\mathbf{h})$ est la densité de probabilité de $\mathbf{h}$ et $d\mathbf{h}$ le volume élémentaire d'espace des coefficients d'évanouissement.

Pour une valeur élevée de $\ell$, on peut majorer $1-(1-P_e(\mathbf{h})^\ell$ par $\min(1,\ell P_e(\mathbf{h}))$, comme indiqué dans l'article de E. Malkamaki et al. intitulé « Evaluating the performance of convolutional codes over block fading channel » publié dans IEEE Trans. on Information Theory, vol. 43, pp. 359-378, May 1994. Le PER peut alors être majoré comme suit:

$$PER \leq \int_{\mathbf{h}} \min\!\big(1, \ell P_e(\mathbf{h})\big) p(\mathbf{h}) d\mathbf{h} \qquad (11)$$

On appelle région de coupure $R_{out}(\gamma,R)$ l'ensemble des points de $\mathfrak{R}^{+^{nc}}$ où $\mathfrak{R}^+$ est l'ensemble des réels positifs, tels que :

$$\forall \mathbf{h} \in R_{out}\big(\gamma, R\big), \quad I(X,Y) < R \qquad (12)$$

D'après la définition de la région de coupure, on sait que si $\mathbf{h} \in R_{out}(\gamma,R)$, la réalisation instantanée du canal ne permet pas un décodage sans erreur, ce qui se traduit par

$$P_e(\mathbf{h}) \geq \frac{1}{\ell} \; .$$

La borne supérieure de l'expression (14) peut alors se décomposer en deux termes, comme suit:

$$PER \leq \int_{\mathbf{h} \in R_{out}} p(\mathbf{h}) d\mathbf{h} + \int_{\mathbf{h} \notin R_{out}} \ell P_e(\gamma, \mathbf{h}) p(\mathbf{h}) d\mathbf{h} \qquad (13)$$

Le premier terme est une composante du taux d'erreur par paquet qui dépend de l'instance du canal. Le second terme est une composante du taux d'erreur par paquet qui dépend du niveau de bruit lorsque l'information mutuelle instantanée est plus grande que le taux binaire de transmission $R$.

L'information mutuelle instantanée du canal, c'est-à-dire, plus précisément ici, calculée sur la durée de transmission du mot de code, peut être évaluée par :

$$I_{inst} = \frac{1}{n_c} \sum_{i=1}^{n_c} I_i \qquad (14)$$

où $I_i$ est l'information mutuelle instantanée calculée sur le bloc $i$. Le comportement du canal sur un bloc peut être considéré, au coefficient multiplicatif $h_i$ près, comme étant de type BBAG.

On suppose que le récepteur connaît les coefficients $h_i$ grâce à la détection de symboles pilotes et que le démodulateur symbole $Q$-aire à bits fournit une estimation de la variance de bruit $\sigma^2$. On peut alors exprimer l'information mutuelle moyenne $I_i$ du canal SISO :

$$I_i = \log Q - \frac{1}{Q}\sum_{k=1}^{Q} E_z \left\{ \log\left( \sum_{q=1}^{Q} \exp\left[ -\frac{\left|h_i a_k + z - h_i a_q\right|^2 - |z|^2}{2\sigma^2} \right] \right) \right\} \qquad (14')$$

où les $a_q$=1,..,$Q$ sont les symboles de l'alphabet de modulation et $z = N(0,\sigma^2)$.

Au lieu d'estimer l'information mutuelle instantanée du canal à partir (14) et (14'), il est possible de l'évaluer empiriquement de manière approchée par:

$$I_{inst} \approx \frac{\gamma}{n_c}\sum_{i=1}^{n_c} |h_i|^2 \qquad (15)$$

Si l'on considère maintenant un canal SISO avec une modulation OFDM, et si l'on suppose qu'un mot de code est modulé sur un seul symbole OFDM, on peut montrer que l'information mutuelle instantanée peut être estimée par:

$$I_{inst} = \frac{1}{K}\log\left[ \det\left( \mathbf{I}_K + \frac{1}{\sigma^2}\mathbf{H}\Sigma\widetilde{\mathbf{H}} \right) \right] \qquad (16)$$

où $K$ est le nombre de porteuses du symbole OFDM (par hypothèse $K = n$), $\mathbf{I}_K$ est la matrice unité de taille $K{\times}K$, $\Sigma$ est la matrice de covariance du vecteur d'entrée, c'est-à-dire du vecteur des symboles de l'alphabet, modulant les différentes porteuses,

$$\mathbf{H} = diag\left\{ h\left( e^{j2\pi\frac{k}{K}} \right) \right\}_{k=0}^{K-1}$$

c'est-à-dire H est la matrice diagonale dont les éléments sont les coefficients d'évanouissement des différentes porteuses et $\widetilde{\mathbf{H}}$ est la transposée conjuguée de $\mathbf{H}$.

Ce résultat peut se généraliser à un canal MIMO avec une modulation OFDM, en considérant $M$ symboles OFDM concaténés comme vecteur d'entrée, où $M$ est, comme indiqué plus haut, le nombre d'antennes d'émission:

$$I_{inst} = \frac{1}{K}\log\left[ \det\left( \mathbf{I}_{KP} + \frac{1}{\sigma^2}\mathbf{H}_\mu\boldsymbol{\Sigma}_\mu\widetilde{\mathbf{H}}_\mu \right) \right] \qquad (17)$$

où $K$ est le nombre de porteuses du symbole OFDM, $P$ est le nombre d'antennes de réception, $\mathbf{I}_{KP}$ est la matrice unité de taille $KP{\times}KP$, $\mathbf{H}_\mu$ est une matrice de taille $KP{\times}KM$ diagonale par blocs, chacun des $K$ blocs étant constitué d'une matrice de taille $P{\times}M$ donnant les coefficients d'évanouissement entre les antennes d'émission et les antennes de propagation à la fréquence d'une porteuse, et $\Sigma_\mu$ est la matrice de covariance de signaux d'entrée, de taille $KM{\times}KM$.

La Fig. 2 représente de manière schématique un récepteur selon un mode de réalisation de l'invention. Le récepteur comprend un démodulateur symbole 210 démodulant le signal d'entrée pour fournir les symboles reçus, un estimateur de canal 220 estimant les coefficients $h_i$ sur la base de symboles pilote $SP_i$ envoyés par l'émetteur. Les symboles d'information reçus $S$ sont ensuite démodulés par le démodulateur 230 fournissant les mots de code $c$ sous la forme de valeurs souples. Il faut noter que, si la modulation est de type BPSK, les symboles BPSK donnent directement les valeurs souples. Les mots de code ainsi obtenus sont ensuite transmis à un décodeur 240, par exemple un décodeur itératif dans le cas d'un turbo-décodeur ou un décodeur à passage de messages. Alternativement, le démodulateur 230 peut fournir des valeurs dures, auquel cas le décodeur 240 est un décodeur ECC (Error Correcting Code) classique n'utilisant pas d'information de fiabilité.

Le récepteur comprend en outre des moyens de décision 250 recevant d'une part, de l'estimateur de canal 220, les estimations des coefficients d'évanouissement $h_i$ et d'autre part, du démodulateur 230, une estimation de la variance de bruit $\sigma^2$ et/ou du rapport signal à bruit $\gamma$. La variance du bruit/ le rapport signal à bruit est calculé(e) par le démodulateur à l'aide des symboles reçus et des symboles correspondants non bruités. Ces derniers sont eux-mêmes obtenus à partir des décisions dures et des estimations des coefficients d'évanouissement. Si les $\hat{\mathbf{x}}_\mathbf{i}$ représentent les symboles décodés après décision dure ou les symboles pilote et $\hat{\mathbf{H}}_\mathbf{i}$ une estimation des coefficients du canal, les échantillons de bruit, et donc leur variance pourront être déterminés par exemple à partir de $\hat{\mathbf{z}}_\mathbf{i} = \mathbf{y}_\mathbf{i} - \hat{\mathbf{H}}_\mathbf{i}\hat{\mathbf{x}}_\mathbf{i}$ où $y_i$ sont les signaux reçus. En pratique, on peut simplement estimer la distance des signaux reçus, après égalisation, aux points de la constellation de modulation et déduire de cette distance la variance de bruit.

Le rapport signal à bruit peut s'obtenir également de manière classique en fonction du taux d'erreur binaire au moyen d'abaques (dans une table de look-up) *BER* = *f*(*S*/*N*).

Les moyens de décision 250 connaissent le type de codage et de modulation utilisé ou MCS (*Modulation and Coding Scheme*), soit de manière implicite soit au moyen d'un message préalable transmis par l'émetteur. En particulier, le récepteur connaît les symboles $a_q$ = 1,..,Q de l'alphabet de modulation.

Ces moyens de décision calculent l'information mutuelle instantanée du canal par exemple selon les expressions (14) et (14'), ou (15) pour un canal SISO, ou selon l'expression (16) pour un canal SISO OFDM ou encore selon l'expression (17) pour un canal MIMO OFDM. Alternativement, les moyens de décision peuvent utiliser une table précalculée stockée en mémoire, indexée par les valeurs des $h_i$, $\gamma$ et/ou $\sigma^2$. La table peut avoir été obtenue par calcul d'une expression analytique telle que (14) et (14'), 15, 16 ou 17 ou bien encore avoir été obtenue par une simulation du canal.

Les moyens de décision 250 comparent l'information mutuelle instantanée du canal ainsi estimée avec le taux binaire de transmission $R$. Si l'information mutuelle instantanée du canal est inférieure au taux binaire de transmission, les moyens de décision 250 inhibent le décodage car celui-ci ne serait pas capable de corriger toutes les erreurs sur le mot de code. En revanche, si l'information mutuelle instantanée du canal est supérieure au taux binaire de transmission, les moyens de décision 250 autorisent le décodage car une correction des erreurs est alors possible. Si le décodage est itératif, un critère d'interruption des itérations, connu en soi, peut alors être appliqué.

Lorsqu'ils inhibent le décodage, les moyens de décision peuvent simultanément déclencher la transmission d'un message de non-acquittement (NACK) pour requérir la retransmission (ARQ) du mot de code. Alternativement, la reprise sur erreur interviendra à un niveau de protocole plus élevé.

Selon une variante de réalisation, l'information mutuelle instantanée du canal, n'est pas comparée à $R$ mais à un seuil réduit, par exemple à $R$-$\delta$ où $\delta$>0 est un offset de seuil qui peut dépendre de nombreux paramètres tels que le niveau de batterie du récepteur, le type de codage, le temps de latence maximal, le type de modulation et notamment du cardinal de l'alphabet de modulation $Q$. Si $I_{inst} < R$-$\delta$, le décodage est inhibé et sinon il est autorisé.

Par exemple, si le niveau de la batterie est élevé ou si le temps de latence maximal est élevé ou encore si $Q$ est faible on pourra choisir une valeur d'offset faible. A l'inverse, si le niveau de batterie est bas ou si le temps de latence maximal est faible ou encore si $Q$ est élevé, on prendra une marge plus importante pour autoriser le décodage, autrement dit l'on prendra une valeur d'offset plus élevée.

Selon encore une variante particulière de réalisation, dans le cas où l'information mutuelle instantanée du canal est telle que $I_{inst} \geq R$-$\delta$, on vérifie en outre si le temps de vie du paquet contenant le mot de code est expiré et, dans l'affirmative, on inhibe le décodage.

## Revendications

1. Récepteur de système de télécommunication sans fil, comprenant un démodulateur (220, 230) adapté à démoduler un signal reçu d'une source via un canal de transmission pour fournir un mot de code correcteur d'erreurs sous forme de valeurs souples ou dures, un décodeur (240) adapté à effectuer le décodage dudit mot de code, **caractérisé en ce qu'**il comprend en outre des moyens de décision (250) adaptés à recevoir une estimation des coefficients d'évanouissement dudit canal pendant la transmission dudit mot de code ainsi qu'une estimation de la variance de bruit ou de rapport signal à bruit, à en déduire une estimation de l'information mutuelle instantanée relative au dit canal, et à décider d'inhiber ou non le décodage du mot de code par le décodeur, selon que le taux binaire de transmission de la source est respectivement supérieur ou inférieur à un seuil caractéristique de ladite information mutuelle instantanée.

2. Récepteur selon la revendication 1, **caractérisé en ce que** l'information mutuelle instantanée est estimée comme l'information mutuelle moyenne entre l'entrée et la sortie dudit canal pendant la durée de transmission du mot de code.

**3.** Récepteur selon la revendication 2, **caractérisé en ce que**, le canal étant du type à une antenne d'émission et une antenne de réception, l'information mutuelle instantanée est calculée selon :

$$I_{inst} = \frac{1}{n_c} \sum_{i=1}^{n_c} I_i$$

$$I_i = \log Q - \frac{1}{Q} \sum_{k=1}^{Q} E_z \left\{ \log \left( \sum_{q=1}^{Q} \exp \left[ -\frac{\left| h_i a_k + z - h_i a_q \right|^2 - \left| z \right|^2}{2\sigma^2} \right] \right) \right\}$$

où $n_c$ est le nombre de coefficients d'évanouissement $h_i; i=1,..,n_c$ du canal affectant le mot de code, $Q$ et $a_k; k=1,..Q$ sont respectivement le cardinal et les éléments de l'alphabet de modulation binaire à symbole utilisée pour moduler le mot de code avant sa transmission sur ledit canal, $\sigma^2$ est la variance du bruit affectant le canal, $z$ un échantillon de bruit suivant une loi $N(0,\sigma^2)$ et $E_z$ l'espérance sur $z$.

**4.** Récepteur selon la revendication 1, **caractérisé en ce que**, le canal étant du type à une antenne d'émission et une antenne de réception, l'information mutuelle instantanée du canal est estimée à partir de :

$$C_{inst} = \frac{\gamma}{n_c} \sum_{i=1}^{n_c} \left| h_i \right|^2$$

où $n_c$ est le nombre de coefficients d'évanouissement $h_i; i=1,..,n_c$ du canal affectant le mot de code et $\gamma$ est le rapport signal à bruit en réception.

**5.** Récepteur selon l'une des revendications précédentes, **caractérisé en ce que** ladite valeur de seuil est égale à l'information mutuelle instantanée du canal diminuée d'une valeur d'offset strictement positive.

**6.** Récepteur selon la revendication 5, **caractérisé en ce que** la valeur d'offset est fonction d'au moins un paramètre appartenant au groupe constitué du niveau de charge de la batterie du récepteur, du type de codage dudit mot de code, du temps de latence maximal, du type de modulation et/ou du cardinal de l'alphabet de modulation utilisé pour moduler ledit mot de code avant sa transmission sur le canal.

**7.** Récepteur selon l'une des revendications précédentes, **caractérisé en ce que** si le temps de vie d'un paquet contenant ledit mot de code est expiré, le décodage est encore inhibé.

**8.** Récepteur selon l'une des revendications précédentes, **caractérisé en ce que** le décodeur effectue un décodage itératif.

**9.** Récepteur selon la revendication 8, **caractérisé en ce que** le décodeur est adapté à interrompre les itérations de décodage sur la base de l'écart entropique des informations *a priori* fournies par deux itérations successives.

**10.** Récepteur selon la revendication 8, **caractérisé en ce que** le décodeur est adapté à interrompre les itérations dudit décodeur sur la base d'une mesure de fiabilité des informations *a priori.*

# FIG. 1

$$c = (n, k, d_{\min})$$

$F_1$    $F_2$    $F_3$    $F_4$    $F_{n_c}$

$$N = \frac{n}{n_c}$$

$\sigma^2,$

| | | | |
|---|---|---|---|
| 210 | $S$ | 230 | $c$ | 240 |

$SP_i$

| 220 | $h_i$ | 250 |

$\sigma^2, \gamma$

# FIG. 2

**Office européen**

**des brevets**

## DECLARATION

qui selon la règle 63 de la Convention sur le brevet
européen est considerée, aux fins de la procédure ultérieure,
comme le rapport de la recherche européenne

Numéro de la demande

EP 07 12 3401

| La division de la recherche estime que la présente demande de brevet n'est pas conforme aux dispositions de la CBE au point qu'une recherche significative sur l'état de la technique ne peut être effectuée au regard de toutes les revendications | CLASSEMENT DE LA DEMANDE     (IPC) |
|---|---|
| Raison : | INV. H03M13/25 |

La revendication 1 définit "des moyens de décisions (250) adaptés à recevoir une estimation des coefficients d'évanouissement dudit canal ... ainsi qu'une estimation de la variance de bruit ou de rapport signal à bruit, à en déduire une estimation de l'information mutuelle instantanée relative au dit canal, et à décider d'inhiber ou non le décodage du mot de code par le décodeur, ..."
Selon les lignes 1-4 de la page 16, "On suppose que le récepteur connaît les coefficients h grâce à la détection de symboles pilotes et que le démodulateur symbole Q-aire à bits fournit une estimation de la variance de bruit ..."
Une évaluation empirique est démontrée dans l'équation (15), qui utilise le rapport signal à bruit gamma.
La demande ne divulgue pas, cependant, comment le démodulateur pourrait faire "une estimation de la variance de bruit ou de rapport signal à bruit". A cause du bruit, le démodulateur ne peut pas garantir des decisions (souples ou dures) correctes, et évidemment une détermination du bruit n'est pas possible. Par exemple, un démodulateur BPSK avec sortie dure donnerait des bits "1" et "0" même si le signal d'entrée consiste seulement en du bruit, et sans décodage il ne serait pas possible de faire une estimation du taux de bruit, cequi explique évidemment pourquoi on utilise souvent un codage du signal; il serait necéssaire, de faire un décodage de la combinaison "signal et bruit" pour obtenir une estimation du signal, et par conséquent aussi une estimation du bruit. Une estimation du

-/--

| Lieu de la recherche | Date | Examinateur |
|---|---|---|
| La Haye | 11 février 2008 | Van Staveren, Martin |

EPO FORM 1504  (P04F38)

**Office européen**

**des brevets**

**DECLARATION**

qui selon la règle 63 de la Convention sur le brevet
européen est considerée, aux fins de la procédure ultérieure,
comme le rapport de la recherche européenne

Numéro de la demande

EP 07 12 3401

| La division de la recherche estime que la présente demande de brevet n'est pas conforme aux dispositions de la CBE au point qu'une recherche significative sur l'état de la technique ne peut être effectuée au regard de toutes les revendications<br><br>Raison :<br><br>        bruit sans décodage, comme définie dans la<br>        revendication, n'est pas possible, et de<br>        ce point de vue, il n'est pas surprenant<br>        que la demande ne divulgue pas comment<br>        cela pourrait être possible.<br><br>        L'attention du déposant est attirée sur le<br>        fait que, suite à une déclaration<br>        conformément à la Règle 63 CBE, une<br>        recherche pourrait être effectuée pendant<br>        la phase d'examen, à condition que les<br>        problèmes ayant conduit à cette<br>        déclaration de non-recherche ou de<br>        recherche incomplète aient été résolus<br>        (voir Directives OEB C-VI, 8.2).<br>                  ----- | **CLASSEMENT DE LA DEMANDE    (IPC)** |
|---|---|
| Lieu de la recherche<br>**La Haye** | Date<br>**11 février 2008** |

| Examinateur |
|---|
| **Van Staveren, Martin** |

EPO FORM 1504 (P04F38)

## RÉFÉRENCES CITÉES DANS LA DESCRIPTION

**Documents brevets cités dans la description**

- EP 1334562 A

- EP 1128589 A

**Littérature non-brevet citée dans la description**

- **J. HAGENAUER et al.** Iterative decoding of binary block and convolutional codes. *IEEE Trans. on Information Theory,* Mars 1996, vol. 42 (2), 429-445
- **R.Y. SHAO et al.** Two simple stopping criteria for turbo decoding. *IEEE Transactions on Communications,* Août 1999, vol. 47, 117-120

- Stopping rules for turbo decoders. **A. MATACHE et al.** TMO Progress report. Jet Propulsion Laboratory, 2000, 42-142
- **E. MALKAMAKI et al.** Evaluating the performance of convolutional codes over block fading channel. *IEEE Trans. on Information Theory,* Mai 1994, vol. 43, 359-378